# EUROPEAN PATENT SPECIFICATION

(11) **EP 0 545 082 B1**
(45) Date of publication and mention of the grant of the patent: **27.09.2000**
(21) Application number: 92118785.2
(22) Date of filing: 02.11.1992
(51) Int. Cl.: H01L 21/76, H01L 21/82

(54) **Process for manufacturing MOS-type integrated circuits comprising LOCOS isolation regions**
Verfahren zur Herstellung von Isolationszonen des LOCOS-Typs für integrierte Schaltungen vom MOS-Typ
Procédé pour fabriquer des circuits intégrés du type MOS utilisant des régions d'isolation du type LOCOS

(30) Priority: 29.11.1991 IT TO910929
(43) Date of publication of application: 09.06.1993
(73) Proprietor: STMicroelectronics S.r.l., 20041 Agrate Brianza (Milano) (IT)
(72) Inventor: Cereda, Manlio Sergio, I-22050 Lomagna (IT); Ginami, Giancarlo, I-24100 Bergamo (IT); Laurin, Enrico, I-20052 Monza (IT); Ravaglia, Andrea, I-24030 Vercurago (IT)
(74) Representative: Cerbaro, Elena, Dr.

(56) References cited:
- EP-A- 0 206 929
- EP-A- 0 428 283
- US-A- 4 663 645
- PATENT ABSTRACTS OF JAPAN vol. 16, no. 185 (E-1197) 6 May 1992 & JP-A-04 022 170 (FUJITSU LTD)
- PATENT ABSTRACTS OF JAPAN vol. 9, no. 35 (E-296) (1758) 14 February 1985 & JP-A-59 178 746 (TOSHIBA K.K.)
- IEDM 1983 DEC.5-7 1983, 1983, NEW-YORK pages 526 - 529 J.Y.-T. CHEN 'AN N-WELL CMOS WITH SELF-ALIGNED CHANNEL STOPS'
- IBM TDB, vol.26, no.3B, August 1983 pages 1318 - 1322 N. LU 'HIGH-CAPACITANCE DYNAMIC RAM CELL USING BURIED POLYSILICON ELECTRODES AND BURIED OXIDE MOS TRANSISTORS'

## Description

The present invention relates to a process for manufacturing MOS-type integrated circuits.

The need for forming large numbers of electrically connected devices on the same substrate requires that the devices be located physically as close together as possible, while at the same time operating independently in the same way as discrete components.

For this purpose, special insulating techniques have been devised for minimizing the space required for ensuring correct insulation of adjacent devices, and so enabling a high degree of integration. Reducing the size of each device, in fact, provides for reducing the total area of the integrated circuit, thus enabling a larger number of circuits to be formed on the same wafer, and a substantial reduction in circuit cost.

One technique widely used for NMOS, PMOS and CMOS circuits is the LOCOS (LOCal Oxidation of Silicon) technique, which consists in defining the active areas by depositing a layer of nitride; implanting channel stoppers in predetermined regions of the substrate through a mask; and growing the field oxide regions in the portions which are not covered by the nitride layer. The major plus features of the LOCOS technique are: simplicity; the possibility of implanting channel stoppers automatically aligned with the active regions (as required for micrometric and submicrometric technology); and precise definition of the active areas.

An example of the LOCOS insulating technique will be described with reference to Fig.s 1-4, which show the formation of an N and P type transistor and EPROM memory cell of an N-well CMOS device.

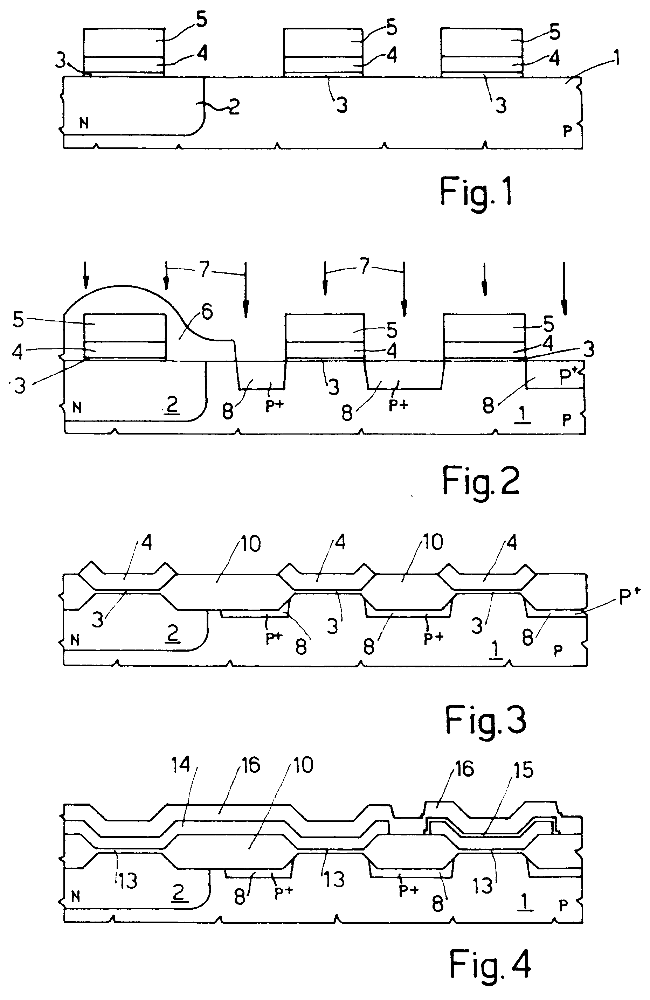

Fig.1 shows an intermediate structure produced by forming N-wells in a P type substrate; growing an oxide layer ("pad oxide"); depositing a layer of nitride; and simultaneously defining the N and P type active areas by masking and subsequently etching the nitride layer. The Fig.1 structure therefore comprises a substrate 1 housing an N-well 2 and selectively covered (in the portions defining the active areas of the finished integrated circuit) with an oxide layer 3, a nitride layer 4, and a resist masking layer 5.

At this point, a second masking operation is performed for protecting the N type regions prior to implanting the channel stoppers, and which consists in covering the N-well region with a resist mask 6 (Fig.2), followed by high-energy boron implantation as shown by arrows 7.

Implantation and diffusion of the boron ions inside the substrate results in the formation of P⁺ type channel stoppers 8 inside the unmasked portions of the substrate, as shown in Fig.2, at which point, resist layers 6 and 5 are removed, and, via field oxidation, field oxide regions 10 are formed, with intrusion of the oxide beneath the nitride layer along the edge of the active areas (thus forming the so-called "field beak"), as shown in Fig.3.

In the example shown, the process continues by removing nitride layer 4; growing a gate oxide layer; depositing and doping (via phosphorus or POCl₃ implantation) a first polysilicon layer; defining said first polysilicon layer in the memory matrix region and the parts of the circuit featuring UPROM (Unerasable Programmable Read Only Memory) cells requiring said first layer for forming the floating gates; growing and removing an oxide layer in the cell-free circuit regions; and depositing a second polysilicon layer using the Double Short Circuited Polysilicon technique whereby the second silicon layer contacts the first in the cell-free circuit regions, and is separated from it in the cell regions by the intermediate oxide layer.

The above phases result in the formation of the intermediate structure shown in Fig.4, which presents substrate 1; well 2; field oxide regions 10; channel stoppers 8; gate oxide layer 13; first polysilicon layer 14; intermediate oxide layer 15; and second polysilicon layer 16. For the sake of simplicity, layers 14 and 16 in Fig.4 are also illustrated separately in the circuit region (to the left) where in actual fact they would merge to form the transistor gates.

In the LOCOS technique described, high-energy implantation as shown by arrows 7 in Fig.2 provides for raising the turn-on threshold voltage of the parasitic transistors formed by the interconnecting lines over the field oxide regions, and which, in the event of an overly thin field oxide region or insufficient doping of the substrate, may result in inversion of the conductivity of the silicon region underlying the field oxide region, thus reducing or even jeopardizing the electric performance of the finished integrated circuit. As the threshold voltage of the parasitic transistors, however, increases in proportion to doping ion concentration, the above phenomenon is prevented by increasing the doping concentration at the silicon-field-oxide interface, so that the threshold voltage of the parasitic transistors is greater than the maximum operating voltage of the integrated circuit. For this purpose, ions of the same type as the substrate (in this case, boron) are high-energy implanted for ensuring correct isolation and preventing segregation of the doping agent in the oxide during field oxidation.

Whereas the threshold voltage of the parasitic transistors increases, the breakdown voltage of the junction formed between the channel stopper and the active areas decreases alongside an increase in doping ion concentration. Moreover, the presence of said junction also creates a parasitic capacitance, due to the depletion region, which is directly proportional to channel stopper concentration close to the active areas. Such conflicting requirements therefore involve a tradeoff, which currently consists in so dosing the channel stopper that the threshold voltage of the parasitic transistor and the breakdown voltage of the junction exceed the maximum voltage of any one part of the device.

As already stated, in the LOCOS technique, formation of the channel stoppers beneath the field oxide regions entails an additional masking stage for preventing the N-well regions from also being doped.

Though widely used, the LOCOS technique is therefore susceptible to improvement as regards the number of masking stages involved, which substantially affect both manufacturing and finished circuit cost, as well as regards the electric characteristics of the device in terms of the threshold voltage of the parasitic transistor.

JP-A-59 178 746 discloses a process for producing MOS-type integrated circuits comprising the steps of: depositing a first layer of semiconductive polycrystalline material on said substrate; selectively removing the first layer of semiconductive polycrystalline material and part of the substrate using a shaping mask; and selectively implanting ions of a selected type of conductivity in the substrate for forming inversion preventing layers (channel stoppers). Then, field insulation regions are grown over the inversion preventing layers and the first layer of polycrystalline material is further shaped through an own mask to form the gate electrode.

The article published on IEDM 1983, 5-7 December 1983, p. 526-529 titled "An N-Well CMOS with Self-Aligned Channel Stops" describes a manufacturing method comprising the steps of forming field insulating regions in the substrate, forming and shaping a metal layer having opening over the field insulating regions; implanting boron ions through the field insulating regions for forming channel stoppers.

EP-A-0 428 283 discloses a method for local oxidation including performing a field implant through the field insulating regions to enhance isolation for N-channel devices.

US-A-4 663 645 discloses a method for manufacturing semiconductor devices including conventional forming of a field insulating film and P-type channel stopper regions therebelow and following conventional steps for shaping a first polysilicon layer to form the floating gate regions of the cells using an own mask and forming the control gate and the gate of transistors from a second polysilicon layer.

EP-A-0 206 929 describes a method for manufacturing an EPROM cell and a transistor.

It is an object of the present invention to provide an improved manufacturing process designed to reduce the number of masking stages involved in forming the channel stoppers, without jeopardizing, indeed, while at the sane time preferably improving, the electric characteristics of the finished device.

According to the present invention, there is provided a process for manufacturing MOS integrated circuits, as claimed in Claim 1.

A preferred, non-limiting embodiment of the present invention will be described by way of example with reference to the accompanying drawings, in which:
Fig.s 1 to 4 show cross sections of a silicon wafer at four different stages of the known LOCOS process, for forming two complementary transistors and a memory cell;
Fig.s 5 to 11 show cross sections of a silicon wafer at different stages in the formation of the Fig. 1-4 components according to the present invention.

In the following description, reference is made solely to Fig.s 5 to 11, the elements of which, similar to those of Fig.s 1 to 4, are indicated using the same numbering system.

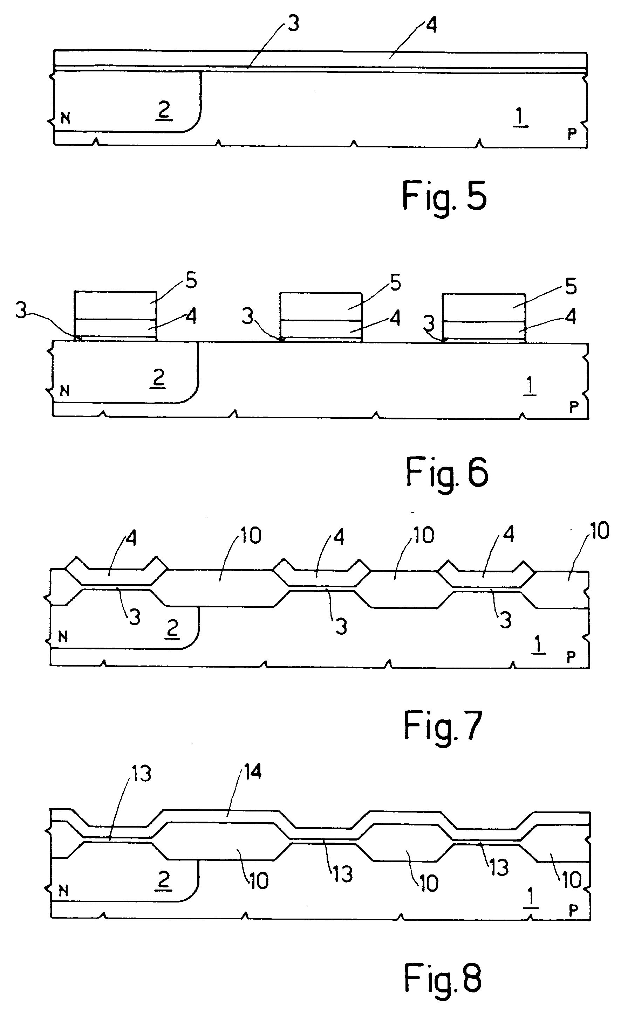

Fig.5 shows a cross section of a silicon wafer consisting of a substrate 1 housing an N-well 2 and on which extend a silicon oxide layer 3 and a nitride layer 4. The Fig.5 structure is masked using known photolithographic techniques, for obtaining the active area mask including resist portions 5 extending over the required field oxide regions; and the exposed portions of nitride layer 4 and oxide layer 3 are removed to produce the Fig.6 structure identical to that of Fig.1.

Unlike the known LOCOS process described previously, immediately following removal of resist layer 5, thick-oxide field insulating regions 10 are grown, with nitride layers 4 being slightly distorted by intrusion (in known manner) of the oxide along the edge of the active areas, to produce the structure shown in Fig.7.

At this point, nitride layer 4 and oxide layer 3 are removed; a gate oxide layer 13 is grown; and a first polysilicon layer 14 is deposited and subsequently doped by implanting phosphorus or POCl₃ in known manner, to produce the Fig.8 structure wherein layer 13, which merges with oxide 10 in the field insulating regions, is shown solely in the active areas.

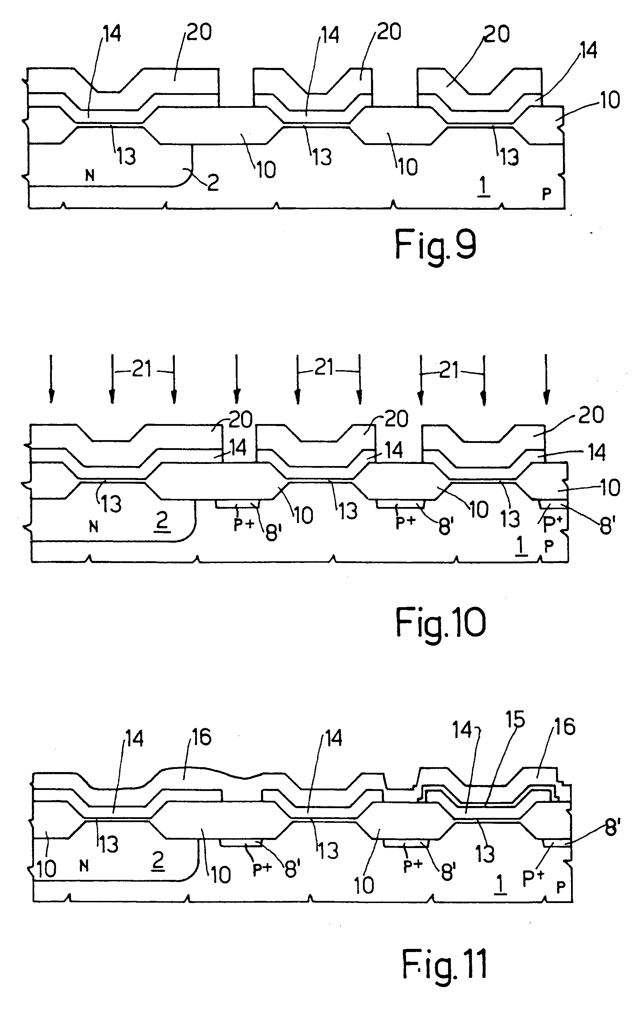

First polysilicon layer 14 is then defined by means of a masking and chemical etching operation, to produce the Fig.9 structure. As can be seen, the resist mask 20 used for defining layer 14 differs from that of the known LOCOS technique in that, in addition to exposing the portions of layer 14 surrounding the memory cell region (to the right) and the UPROM cell region (not shown), it also exposes layer 14 over the field insulating regions 10 formed in the P type substrate, i.e. the regions in which the channel stoppers are to be formed.

Subsequently, after removing the exposed portions of polysilicon layer 14, boron ions are implanted as shown by arrows 21 in Fig.10. This is performed in high-energy manner, to penetrate the full thickness of field oxide layer 10 (typically 500-700 nm (5000-7000 Å)), and results in the formation of small boron ion layers 8' underlying field insulating regions 10 and forming P⁺ type channel stoppers after diffusion.

Following implantation of layers 8', photoresist mask 20 used for defining first polysilicon layer 14 and implanting channel stoppers 8' is removed; an oxide layer 15 is grown for insulating the polysilicon layers; oxide layer 15 is removed selectively, by masking, from the circuit component portions; and a second polysilicon layer 16 is deposited, to produce the structure shown in Fig.11.

The next stages in the process consist in forming the various components in and on the substrate, according to the circuit and technique in question, and more specifically, in doping second polysilicon layer 16; defining the transistor gates; implanting the transistor source and drain regions; and, finally, protecting and interconnecting the devices.

In other words, in the described process first polysilicon layer 14 and the photoresist mask 20 employed for defining the same protect the active areas and N-well regions at the channel stopper implantation stage, thus eliminating the need for an additional mask and so reducing the total number of masking stages for producing the circuit.

The advantages of the described process will be clear from the foregoing description. In particular, besides eliminating one masking stage, as described above, and so reducing production time and cost, the process according to the present invention also provides for improved electric performance by enabling implantation of the channel stoppers at a slightly greater distance from the active areas as compared with the known LOCOS technique wherein the stoppers are selfaligned. Moreover, the doping ions implanted subsequent to field oxidation are not involved in the field oxidation itself and in the oxidation necessary to form the gate oxide layer 13, and, by virtue of not being subjected to the relative heat processes, diffuse to a lesser degree, thus further reducing doping ion concentration close to the active areas and, consequently, increasing breakdown voltage and reducing parasitic capacitance, with no reduction in the turn-on threshold of the parasitic transistors.

## Claims

1. A process for producing MOS-type integrated circuits including N and P channel MOS devices formed in substrate portions (1, 2) of opposite conductivity and memory cell devices having two layers of semiconductive material separated by field insulating regions, the process comprising the steps of:
selectively growing field insulating regions (10) of insulating material extending partly inside a substrate (1) of semiconductive material;
depositing a first layer (14) of semiconductive polycrystalline material on said substrate (1); and said field insulting regions (10);
shaping said first layer (14) of semiconductive polycrystalline material using a floating gate shaping mask (20), said shaping mask (20) having openings over field insulating regions (10) housed in first portions (1) of said substrate having a first conductivity type; said mask (20) covering second portions (2) of said substrate having a second conductivity type;
thereafter, selectively implanting (21) ions of a selected type of conductivity in said substrate (1) through said predetermined field insulating regions (10) using said floating gate shaping mask, for forming channel stopper regions (8') beneath said predetermined field insulating regions (10);
subsequently, removing said shaping mask (20) and depositing an electrically insulating layer (15);
selectively removing said electrically insulating layer from the transistor device portions;
depositing a second layer (16) of semiconductive polycrystalline material, said second layer (16) being in direct electrical contact with said first layer (14) at said transistor device portions; and
shaping transistor gate regions and cell control gate regions of said devices.

2. A process as claimed in Claim 1, characterized in that said selective implantation step (21) is a high-energy implantation step.

3. A process as claimed in one of Claims 1 or 2, characterized in that said substrate (1) has said selected conductivity type.

4. A process as claimed in one or more of the foregoing Claims, characterized in that said selected type of conductivity is a P type, and said ions comprise boron.

## Patentansprüche

1. Ein Verfahren zur Herstellung von integrierten Schaltungen des MOS-Typs, die N- und P-Kanal-MOS-Vorrichtungen, geformt in Substratteilen (1,2) mit entgegengesetzter Leitfähigkeit aufweisen und ferner von Speicherzellenvorrichtungen mit zwei Schichten von Halbleitermaterial, separiert durch feldisolierende Regionen, wobei das Verfahren die folgenden Schritte aufweist:
selektives Aufwachsen von feldisolierenden Regionen (10) aus isolierendem Material, die sich zum Teil in ein Substrat (1) aus Halbleitermaterial erstrecken;
Ablagern einer ersten Schicht (14) aus halbleiter-polykristallinem Material auf dem Substrat (1) und auf die feldisolierenden Regionen (10); Formen der ersten Schicht (14) aus halbleiter-polykristallinem Material mittels einer freischwebenden Gate formenden Maske (20) (floating gate shaping mask), wobei die Formmaske (20) Öffnungen über den feldisolierenden Regionen (10) hat aufgenommen in den ersten Teilen (1) des Substrats, mit einem ersten Leitfähigkeitstyp, wobei die Maske (20) die zweiten Teile (2) des Substrats mit einem zweiten Leitfähigkeitstyp abdeckt;
danach, selektives Implantieren (21) von Ionen eines gewählten Leitfähigkeitstyps in das Substrat (1) durch die vorbestimmten feldisolierenden Regionen (10) mittels der freischwebenden Gate formenden Maske, zum Bilden von Kanalstopperregionen (8') unterhalb der vorbestimmten feldisolierenden Regionen (10);
danach, Entfernen der Formungsmaske (20) und Ablagern einer elektrisch isolierenden Schicht 15;
selektives Entfernen der elektrisch isolierenden Schicht von den Transistorvorrichtungsteilen;
Ablagern einer zweiten Schicht (16) von halbleiter-polykristallinem Material, wobei die zweite Schicht (16) in direktem elektrischen Kontakt mit der ersten Schicht (14) ist und zwar an den Transistorvorrichtungsteilen; und
Formen der Transistorgateregionen und der Zellsteuerungsgateregionen der Vorrichtungen.

2. Ein Verfahren nach Anspruch 1, dadurch gekennzeichnet, daß der selektive Implantierungsschritt (21) ein hochenergetischer Implantierungsschritt ist.

3. Ein Verfahren nach Anspruch 1 oder 2, dadurch gekennzeichnet, daß das Substrat (1) den gewählten Leitfähigkeitstyp hat.

4. Ein Verfahren nach einem oder mehreren der vorhergehenden Ansprüche, dadurch gekennzeichnet, daß der gewählte Leitfähigkeistyps P-dotiert ist und daß die Ionen Bor umfassen.

## Revendications

1. Procédé de fabrication de circuits intégrés de type MOS comprenant des dispositifs MOS à canal N et P formés dans des parties de substrat (1, 2) de types de conductivité opposés et des dispositifs de cellules mémoire comprenant deux couches de matériau semiconducteur séparées par des régions d'isolement de champ, le procédé comprenant les étapes suivantes :
faire croître sélectivement des régions d'isolement de champ (10) du matériau isolant s'étendant partiellement dans un substrat (1) de matériau semiconducteur ;
déposer une première couche (14) de matériau semiconducteur polycristallin sur le substrat (1) et les régions d'isolement de champ (10) ;
délimiter la première couche (14) de matériau semiconducteur polycristallin en utilisant un masque (20) de délimitation de grille flottante, ledit masque (20) comprenant des ouvertures au-dessus des régions d'isolement de champ (10) logées dans des première parties du substrat ayant un premier type de conductivité ; ledit masque (20) recouvrant des seconde parties (2) du substrat ayant un second type de conductivité ;
implanter ensuite sélectivement (21) des ions d'un type de conductivité choisi dans le substrat (1) à travers les régions d'isolement de champ prédéterminées (10) en utilisant le masque de délimitation de grille flottante, pour former des régions d'arrêt de canal (8') en dessous des régions d'isolement de champ prédéterminées (10) ;
ensuite, enlever le masque de délimitation (20) et déposer une couche électriquement isolante (15) ;
enlever sélectivement la couche électriquement isolante des parties de transistors ;
déposer une seconde couche (16) de matériau semiconducteur polycristallin, la seconde couche (16) étant en contact électrique direct avec la première couche (14), au niveau des parties de transistors ; et
délimiter les régions de grilles de transistors et les régions de grilles de commande des cellules mémoire.

2. Procédé selon la revendication 1, caractérisé en ce que l'étape d'implantation sélective (21) est une étape d'implantation à haute énergie.

3. Procédé selon la revendication 1 ou 2, caractérisé en ce que le substrat (1) a le type de conductivité choisi.

4. Procédé selon une ou plusieurs des revendications précédentes, caractérisé en ce que le type de conductivité choisi est le type P et lesdits ions comprennent du bore.
